# EUROPÄISCHE PATENTSCHRIFT

(11) **EP 0 362 641 B1**
(45) Veröffentlichungstag und Bekanntmachung des Hinweises auf die Patenterteilung: **20.12.1995**
(21) Anmeldenummer: 89117540.8
(22) Anmeldetag: 22.09.1989
(51) Int. Cl.: G03F 7/16

(54) **Kontinuierliches Verfahren zur Herstellung eines lichtempfindlichen Aufzeichnungselements**
Continuous process for the production of a light-sensitive recording element
Procédé continu pour la fabrication d'un élément photosensible pour l'enregistrement

(30) Priorität: 04.10.1988 DE 3833650
(43) Veröffentlichungstag der Anmeldung: 11.04.1990
(73) Patentinhaber: BASF Aktiengesellschaft, 67063 Ludwigshafen (DE)
(72) Erfinder: Koch, Horst, Dr., D-6718 Gruenstadt (DE); Kurtz, Karl-Rudolf, Dr., D-6900 Heidelberg (DE); Telser, Thomas, Dr., D-6940 Weinheim (DE); Zuerger, Manfed, D-6920 Sinsheim (DE)

(56) Entgegenhaltungen:
- Keine einschlägigen Dokumente gefunden

## Beschreibung

Die vorliegende Erfindung betrifft ein neues, verbessertes kontinuierliches Verfahren zur Herstellung eines lichtempfindlichen Aufzeichnungselements mit einer photopolymerisierbaren Aufzeichnungsschicht (A), bei welchem die photopolymerisierbare Aufzeichnungsschicht (A) aus mindestens zwei übereinanderliegenden Einzelschichten (aₙ) von stofflich gleicher, in etwa gleicher oder unterschiedlicher Zusammensetzung durch deren haftfestes Verbinden im Spalt eines Kalanders in einem Arbeitsgang aufgebaut wird.

Ein lichtempfindliches Aufzeichnungsmaterial, dessen photopolymerisierbare Aufzeichnungsschicht (A) aus übereinanderliegenden Einzelschichten (aₙ) von stofflich gleicher, in etwa gleicher oder unterschiedlicher Zusammensetzung besteht, ist aus der DE-A-29 42 183 bekannt. Aus der DE-A-29 42 183 geht außerdem die allgemeine Empfehlung hervor, daß man die Einzelschichten (aₙ) unter Ausnutzung ihrer natürlichen Eigenklebrigkeit oder unter Verwendung anlösender Lösungsmittel zu einer einzigen photopolymerisierbaren Aufzeichnungsschicht (A) zusammenlaminieren kann. Hierbei können zur Erzielung spezieller Eigenschaften Einzelschichten (aₙ) unterschiedlicher Rezepturen verwendet werden, wobei die Einzelschichten (aₙ) mit Hilfe bekannter Techniken in einem Arbeitsgang extrudiert, kalandriert oder gepreßt werden können. Wie dies im einzelnen geschehen soll, geht indes nicht aus der DE-A-29 42 183 hervor.

Spezielle Extrusions- und Kalandrierverfahren für die Herstellung von lichtempfindlichen Aufzeichnungselementen mit einer photopolymerisierbaren Aufzeichnungsschicht (A) sind aus der EP-B-0 084 851, der EP-A-0 185 337 und aus der EP-A-0 080 665 bekannt.

So ist es aus der EP-A-0 080 665 bekannt, ein photopolymerisierbares Gemisch durch Extrusion in einem Mehrfachwellenentgasungsextruder herzustellen, aus einer nachgeschalteten Breitschlitzdüse auszutragen und in den Spalt eines Kalanders so einzuführen, daß sich hierbei ein rotierender Massewulst bildet. Durch dieses Verfahren läßt sich die photopolymerisierbare Aufzeichnungsschicht (A) mit hoher Dickengenauigkeit und -konstanz formen. Die photopolymerisierbare Aufzeichnungsschicht (A) kann außerdem bereits im Kalanderspalt mit einem dimensionsstabilen Träger (B) und einer von der Oberfläche der photopolymerisierbaren Aufzeichnungsschicht (A) leicht ablösbaren Deckfolie (D) verbunden werden, wodurch ein lichtempfindliches Aufzeichnungselement mit dem Aufbau (B+A+D) resultiert. Indes wird dieses Verfahren lediglich zur Herstellung eines lichtempfindlichen Aufzeichnungsmaterials ausgeführt, dessen photopolymerisierbare Aufzeichnungsschicht (A) nicht aus haftfest miteinander verbunden Einzelschichten (aₙ) aufgebaut ist.

Bei dem Verfahren gemäß der EP-B-0 084 851 wird ein photopolymerisierbares Gemisch zwischen einem dimensionsstabilen Träger (B) und einem mehrschichtigen Deckelement aus einer elastomeren Schicht, gegebenfalls einer löslichen, flexiblen Deckschicht (C) und einer von der elastomeren Schicht oder von der löslichen, flexiblen Deckschicht (C) leicht wieder abziehbaren Deckfolie (D) im Spalt eines Kalanders kalandriert, so daß das photopolymerisierbare Gemisch eine photopolymerisierbare Aufzeichnungsschicht (A) zwischen dem Träger (B) und dem mehrschichtigen Deckelement bildet. Allerdings kann das Auftragen des mehrschichtigen Deckelements auch nach dem Kalandrieren durch Laminieren oder Pressen erfolgen.

Die EP-A-0 185 337 richtet sich auf eine Ausgestaltung des aus der EP-A-0 084 851 bekannten Verfahrens, wobei die Ausgestaltung ausschließlich die Herstellung des mehrschichtigen Deckelements aus der elastomeren Schicht, gegenenfalls der löslichen, flexiblen Deckschicht (C) sowie der Deckschicht (D) betrifft. Die Ausgestaltung besteht darin, daß man bei der Herstellung des mehrschichtigen Deckelements wenigstens die elastomere Schicht durch
(i) Extrusion und durch
(ii) Strecken ("stretching") formt, wonach man sie
(iii) auf ihrer einen Seite mit der Deckfolie (D) bedeckt.

Hiernach kann die danach freibleibende Seite der elastomeren Schicht mit einer ablösbaren Folie verbunden werden, welche dem zeitweiligen Schutz der elastomeren Schicht dient.

Gemäß einer zusätzlichen Verfahrensvariante wird das mehrschichtige Deckelement aus der elastomeren Schicht, der löslichen, flexiblen Deckschicht (C) und der hiervon leicht ablösbaren Deckfolie (D) durch
(i) getrennte Extrusion der Gemische, welche der Herstellung der elastomeren Schicht und der Deckschicht (C) dienen, in zwei Extrudern,
(ii) vermischungsfreies Zusammenführen dieser beiden extrudierten Gemische mittels eines Adapters, welcher beiden Extrudern gemeinsam ist,
(iii) Austragen der zusammengeführten geschmolzenen Gemische durch eine dem Adapter nachgeschalteten Breitschlitzdüse als Doppelschicht und durch
(iv) verbinden der Doppelschicht aus elastomerer Schicht und Deckschicht (C) mit der von der Oberfläche der Deckschicht (C) leicht abziehbaren Deckfolie (D) in einem Kalander

hergestellt.

Die bislang bekannt Verfahren zur Herstellung eines lichtempfindlichen Aufzeichnungselements mit einer photopolymerisierbaren Aufzeichnungsschicht (A), welche aus übereinanderliegenden und haftfest miteinander verbundenen Einzelschichten (aₙ) besteht, weisen Nachteile auf.

So läßt sich nach den bislang bekannten Verfahren die photopolymerisierbare Aufzeichnungsschicht (A) nicht in einem einfachen Arbeitsgang aus Einzelschichten (aₙ) herstellen, sondern die Einzelschichten (aₙ) müssen in unterschiedlicher Art und Weise, zu unterschiedlichen Zeitpunkten und/oder in verschiedenen Anlagen hergestellt werden. Dies schafft Probleme hinsichtlich der Abstimmung der stofflichen und apparativen Parameter aufeinander und der Abfolge der einzelnen Verfahrensschritte. Hieraus entstehen oftmals Schwierigkeiten bezüglich der Reproduzierbarkeit der Verfahrensbedingungen, woraus sich direkt ein variierendes Eigenschaftsprofil der Verfahrensprodukte ergibt. So kommt es beispielsweise häufig zu Schwankungen in der Dicke der Einzelschichten (aₙ) der photopolymerisierbaren Aufzeichnungsschicht (A), und/oder die Einzelschichten (aₙ) haften nicht mehr fest aufeinander, so daß die betreffende photopolymerisierbare Aufzeichnungsschicht (A) für die Weiterverarbeitung nur wenig oder gar nicht mehr geeignet ist. Die Nachteile der bislang bekannten Verfahren machen sich selbstverständlich auch an den hiermit erzeugten Verfahrensprodukten - den lichtempfindlichen Aufzeichnungselementen - bemerkbar. Werden diese in bekannter Weise hergestellten, lichtempfindlichen Aufzeichnungselemente mit aktinischem Licht bildmäßig belichtet und hiernach entwickelt, resultieren Reliefdruckplatten, deren anwendungstechnisches Eigenschaftsprofil den wachsenden Anforderungen der Praxis nicht genügt. So geben diese Reliefdruckplatten das Motiv der Negativvorlage nicht in der geforderten Datailgetreuheit wieder, was sich insbesondere an sehr feinen und daher kritischen Bildelementen störend bemerkbar macht. Außerdem entspricht die Lebensdauer dieser Reliefdruckplatten unter Druckbedingungen nicht den in sie gesetzten Erwartungen, so daß auch ihre Wiederverwendbarkeit beeinträchtigt ist.

Aufgabe der vorliegenden Erfindung ist es, ein neues, verbessertes kontinuierliches Verfahren zur Herstellung lichtempfindlicher Aufzeichnungselemente mit einer photopolymerisierbaren Aufzeichnungsschicht (A) zu finden, welches die Nachteile des Standes der Technik nicht mehr länger aufweist und welches lichtempfindliche Aufzeichnungselemente liefert, die sich nach ihrer bildmäßigen Belichtung mit aktinischem Licht und nach ihrer Entwicklung hervorragend für den Reliefdruck eignen.

Demgemäß wurde ein kontinuierliches Verfahren zur Herstellung eines lichtempfindlichen Aufzeichnungselements mit einer photopolymerisierbaren Aufzeichnungsschicht (A) gefunden, bei welchem die photopolymerisierbare Aufzeichnungsschicht (A) aus mindestens zwei übereinanderliegenden Einzelschichten (aₙ) von stofflich gleicher, in etwa gleicher oder unterschiedlicher Zusammensetzung durch deren haftfestes Verbinden im Spalt eines Kalanders in einem Arbeitsgang erzeugt wird und welches dadurch gekennzeichnet ist, daß man hierbei
(1) die der Herstellung der Einzelschichten (aₙ) dienenden Gemische (aₙ) getrennt voneinander aufschmilzt und als getrennte Stoffströme (aₙ) in geschmolzenem Zustand bereits vor ihrem Eintritt in den Kalanderspalt zusammenführt, ohne sie dabei durch Verwirbelung zu vermischen, wobei
(2) die geschmolzenen Stoffströme (aₙ) vor ihrem Eintritt in den Kalanderspalt bereits vor, bei oder unmittelbar nach ihrem Zusammenführen zu übereinanderliegenden geschmolzenen flächigen Gebilden (aₙ) geformt werden, ohne sie dabei durch Verwirbelung zu vermischen, wonach man
(3) die übereinanderliegenden geschmolzenen flächigen Gebilde (aₙ) in den Kalanderspalt einführt, wobei mindestens eines der beiden mit den Kalanderwalzen in Kontakt stehenden, äußeren geschmolzenen flächigen Gebilde (aₙ) einen rotierenden Massewulst bildet, und
(4) die übereinanderliegenden geschmolzenen flächigen Gebilde (aₙ) unter Erzeugung der aus übereinanderliegenden und haftfest miteinander verbundenen Einzelschichten (aₙ) bestehenden photopolymerisierbaren Aufzeichnungsschicht (A) kalandriert.

Im folgenden wird das erfindungsgemäße kontinuierliche Verfahren zur Herstellung eines lichtempfindlichen Aufzeichnungsmaterials mit einer photopolymerisierbaren Aufzeichnungsschicht (A), welche aus übereinanderliegenden und haftfest miteinander verbundenen Einzelschichten (aₙ) besteht, der Kürze halber als "erfindungsgemäßes Verfahren" bezeichnet.

Im Rahmen der vorliegenden Erfindung bezieht sich der Index "n" auf die Reihenfolge, in welcher die Einzelschichten (a) in der photopolymerisierbaren Aufzeichnungsschicht (A) übereinander liegen, wobei der Index der obersten Einzelschicht (aₙ) zugleich die Anzahl der vorhandenen Einzelschichten (aₙ) angibt. Er ist demnach eine ganze Zahl, welche Werte von 1 bis n haben kann.

Das erfindungsgemäße Verfahren geht von der Herstellung der Gemische (aₙ) aus, welche der Herstellung der Einzelschichten (aₙ) dienen. Die Anzahl der bei dem erfindungsgemäßen Verfahren verwendeten Gemische (aₙ) richtet sich nach der Anzahl an Einzelschichten (aₙ), welche letztlich die photopolymerisierbare Aufzeichnungsschicht (A) des lichtempfindlichen Aufzeichnungselements aufbauen. Das erfindungsgemäße Verfahren wird mit mindestens zwei Gemischen (a₁) und (a₂) durchgeführt. Es können jedoch auch mehr als zwei Gemische (a_{1,2,3 bis n}) verwendet werden, wobei es für das erfindungsgemäße Verfahren und für die Verfahrensprodukte von Vorteil ist, zwei, drei, vier, fünf oder sechs Gemische (aₙ) zu verwenden. In ganz speziellen Fällen können auch mehr als sechs Gemische (aₙ), wie etwa sieben, acht oder neun, angewendet werden. Der Vorteil, welcher sich hieraus für die Verfahrensprodukte - die lichtempfindlichen Aufzeichnungselemente - ergibt, wird jedoch meist durch den höheren apparativen Aufwand kompensiert. Am vorteihaftesten wird das erfindungsgemäße Verfahren mit zwei bis vier Gemischen (aₙ) ausgeführt, wobei sowohl von der Verfahrenstechnik als auch von der Produktqualität her gesehen, die Verwendung von zwei oder drei Gemischen (aₙ) ein Optimum ist.

Das Mengenverhältnis, in welchem die Gemische (aₙ) zueinander stehen, richtet sich ausschließlich danach, wie dick die aus den Gemischen (aₙ) hergestellten Einzelschichten (aₙ) in der photopolymerisierbaren Aufzeichnungsschicht (A) sein sollen.

Die Gemische (aₙ), welche für die Durchführung des erfindungsgemäßen Verfahrens jeweils verwendet werden, können von stofflich gleicher Zusammensetzung sein, d.h., sie sind sowohl hinsichtlich ihrer Komponenten als auch hinsichtlich dem Mengenverhältnis, in welchem diese Komponenten zueinander stehen, identisch.

Die Gemische (aₙ), welche für das erfindungsgemäße Verfahren jeweils verwendet werden, können indes auch von stofflich in etwa gleicher Zusammensetzung sein. Dies bedeutet, daß die einzelnen Gemische (aₙ) sich lediglich geringfügig voneinander unterscheiden. Der Unterschied kann dabei im Mengenverhältnis der Komponenten zueinander oder in der Verwendung unterschiedlicher, aber in vergleichsweise geringen Mengen vorliegender Komponenten begründet liegen.

Die Gemische (aₙ), welche für die Durchführung des erfindungsgemäßen Verfahrens verwendet werden, können aber auch von stofflich unterschiedlicher Zusammensetzung sein. Dies bedeutet, daß sie sich hinsichtlich ihres Gehalts an wesentlichen Komponenten deutlich voneinander unterscheiden.

Selbstverständlich können bei dem erfindungsgemäßen Verfahren zugleich Gemische (aₙ) verwendet werden, von denen z.B. zwei stofflich gleich sind, wogegen sich die übrigen Gemische (aₙ) von diesen beiden Gemischen (aₙ) geringfügig und/oder deutlich unterscheiden.

Die Gemische (aₙ) sind für sich selbst gesehen photopolymerisierbar oder sie werden im Verlauf der Durchführung des erfindungsgemäßen Verfahrens durch den Kontakt mit mindestens einem aus einem solchen photopolymerisierbaren Gemisch (aₙ) hergestellten geschmolzenen Stoffstrom (aₙ), einem geschmolzenen flächigen Gebilde (aₙ) oder einer geschmolzenen Einzelschicht (aₙ) photopolymerisierbar. Obligatorisch ist bei dem erfindungsgemäßen Verfahren mindestens ein photopolymerisierbares Gemisch (aₙ) anzuwenden, durch welches letztlich die Photopolymerisierbarkeit mindestens einer weiteren geschmolzenen Einzelschicht (aₙ) hervorgerufen wird. Indessen können auch zwei, drei und mehr der Gemische (aₙ) für sich selbst gesehen photopolymerisierbar sein. Die Entscheidung, ob man das erfindungsgemäße Verfahren mit lediglich einem oder mit zwei und mehr oder ausschließlich mit photopolymerisierbaren Gemischen (aₙ) durchführen will, richtet sich ausschließlich nach dem gewünschten Eigenschaftsprofil, welches die photopolymerisierbare Aufzeichnungsschicht (A) des lichtempfindlichen Aufzeichnungselements haben soll.

Erfindungsgemäß werden die Gemische (aₙ) separat voneinander hergestellt, wonach sie im geschmolzenen Zustand vorliegen. Verfahrenstechnisch bietet die Herstellung der Gemisch (aₙ) keine Besonderheiten, sondern sie erfolgt nach den üblichen und bekannten Methoden der Herstellung von Gemischen, welche in der Hauptsache Polymere, insbesondere Elastomere, enthalten. Demgemäß kommen hier die üblichen und bekannten Knet-, Lösungs- oder Extrusionsmethoden in Betracht, wie sie üblicherweise mit Hilfe von Knetern, Rührkesseln oder Einschnecken- und Mehrfachwellenentgasungsextrudern durchgeführt werden. Vorteilhafterweise erfolgt die Herstellung der Gemische (aₙ) aus ihren Komponenten in Extrudern, wobei die Verwendung von Mehrfachwellenentgasungsextrudern von ganz besonderem Vorteil ist. Hierbei richten sich die Bedingungen, unter welchen die Extrusion erfolgt, nach der gewünschten Zusammensetzung der Gemische (aₙ), ihrer aus der jeweiligen Zusammensetzung resultierenden Viskosität, nach der thermischen Belastbarkeit der verwendeten Komponenten und danach, ob diese Komponenten flüssig oder fest sind. In zahlreichen Fällen haben sich die in der EP-B-0 080 660 beschriebenen Mehrfachwellenentgasungsextruder sowie die dort beschriebenen Extrusionsbedingungen bewährt.

Bei den Komponenten, welche der Herstellung geeigneter Gemische (aₙ) dienen, handelt es sich um Stoffe wie sie üblicherweise für die Herstellung photopolymerisierbarer Aufzeichnungsschichten (A) verwendet werden.

Gut geeignete Gemische (aₙ) enthalten dabei im wesentlichen
(i) ein oder mehrere Polymere als Bindemittel, wobei die Polymere auch seiten- oder endständige photopolymerisierbare olefinisch ungesättigte Reste enthalten können,
(ii) einen oder mehrere Photopolymerisationsinitiatoren,
(iii) eine oder mehrere mit dem Bindemittel verträgliche, photopolymerisierbare olefinisch ungesättigte Verbindungen (Monomere) und gegebenenfalls
(iv) einen oder mehrere Hilfsstoffe, mit deren Hilfe das anwendungstechnische Eigenschaftsprofil variiert wird.

Die Kennzeichnung "verträglich" zeigt an, daß die betreffende Komponente in dem jeweiligen Gemisch (aₙ) molekulardispers verteilt werden kann, hierin keine Trübung hervorruft und sich auch im Laufe der Zeit nicht entmischt.

Unter "Variation des Eigenschaftsprofils" ist die gezielte Verbesserung bestimmter anwendungstechnischer Eigenschaften von photopolymerisierbaren Aufzeichnungsschichten (A) und von hieraus hergestellten photopolymerisierten Reliefschichten (A′) zu verstehen. Diese Verbesserungen machen sich vor allem bei photopolymerisierte Reliefschichten (A′) enthaltenden Reliefdruckplatten und Photoresists bemerkbar und werden allgemein durch Zugabe üblicher und bekannter Zusatzstoffe zu den photopolymerisierbaren Aufzeichnungsschichten (A) erzielt. Diese Zusatzstoffe werden daher oftmals auch als "Hilfsstoffe" bezeichnet.

Für die Herstellung der Gemische (aₙ) werden die polymeren Bindemittel üblicherweise in einer Menge von 20 bis 99, vorzugsweise 30 bis 90 und insbesondere 40 bis 85 Gew.%, bezogen auf die Gesamtmenge des jeweils herzustellenden Gemisch (aₙ), verwendet.

Polymere Bindemittel, welche für diesen Verwendungszweck gut geeignet sind, entstammen den Polymerklassen der Polyamide, Copolyamide, Polyester, Polyurethane, Polyalkadiene, Vinylaromat/Alkadien-Copolymerisate und Blockmischpolymerisate, Alkadien/Acrylnitril-Copolymerisate, Butylkautschuke, Acrylatkautschuke, Polychloroprene, Fluorkautschuke, Polysulfitkautschuke, Siliconkautschuke, Ethylen/Propylen-Copolymerisate, der chlorsulfonierten Polyethylene, der Ethylen/(Meth)acrylat-, Ethylen/Vinylacetat- und Ethylen/(Meth)acrylsäure-Copolymerisate, Alkadien/(Meth)Acrylsäure-Copolymerisate und der (Meth)acrylsäure/(Meth)acrylat-Copolymerisate. Diese als Bindemittel gut geeigneten Polymere sind bekannte Verbindungen und werden durch übliche und bekannte Methoden der Polymerchemie erhalten.

Besonders gut geeignete Bindemittel entstammen den Polymerklassen der Polyamide, Copolyamide, Polyalkadiene, Vinylaromat/Alkadien-Copolymerisate und -Blockmischpolymerisate, Alkadien/Acrylnitril-Copolymerisate, Ethylen/Propylen-Copolymerisate, Ethylen/(Meth)Acrylsäure-Copolymerisate und der Alkadien/(Meth)Acrylsäure-Copolymerisate.

Beispiele besonders gut geeigneter polymerer Bindemittel aus der Klasse der Polyamide oder Copolyamide sind lineare Homo- und Copolyamide, die in bekannter Weise aus bifunktionellen Carbonsäuren und Diaminen oder aus ω-Aminosäuren, Lactamen oder aus geeigneten Derivaten dieser Verbindungen hergestellt werden.

Beispiele besonders gut geeigneter Bindemittel aus der Polymerklasse der Alkadiene sind Naturkautschuk, die Homopolymerisate von Butadien oder Isopren sowie Butadien/Isopren-Copolymerisate.

Beispiele besonders gut geeigneter Bindemittel aus der Polymerklasse der Vinylaromat/Alkadien-Copolymerisate sind Copolymerisate aus Styrol und Butadien und/oder Isopren mit statistischer Verteilung der einpolymerisierten Monomeren und einem Gehalt an einpolymerisiertem Styrol von vorzugsweise 10 bis 50 Gew.%, bezogen auf das Copolymerisat.

Beispiele besonders gut geeigneter Bindemittel aus der Polymerklasse der Vinylaromat/Alkadien-Blockmischpolymerisate sind diejenigen, welche mindestens einen elastomeren Dien-Polymerisatblock X und mindestens einen thermoplastischen Vinylaromaten-Polymerisatblock Y enthalten.

Beispiele für Vorteilhafte Alkadiene sind Butadien, Isopren, Pentan-1,3-dien, 2,3-Dimethylbutadien oder Hexan-2,4-dien, wobei Butadien und/oder Isopren bevorzugt sind.

Beispiele für Vorteilhafte Vinylaromaten sind Styrol, α-Methylstyrol, p-Methylstyrol, p-tert.-Butylstyrol oder 1-Vinylnaphthalin, wobei Styrol bevorzugt ist.

Als Beispiele für besonders gut geeignete Blockmischpolymerisate seien die thermoplastisch elastomeren Dreiblockmischpolymerisate Y-X-X′ in denen Y einen thermoplastischen, nicht elastischen Styrolpolymerisatblock, X einen elastomeren Butadien- und/oder Isoprenpolymerisat-Block und Y′ einen von X verschiedenen elastomeren Polymerisat-Block aus einpolymerisiertem Butadien und/oder Isopren sowie gegebenenfalls einpolymerisiertem Styrol darstellt.

Als weitere Beispiele für besonders gut geeignete Blockmischpolymerisate seien Vierblockmischpolymerisate, wie X-Y-X-Y, Y-X-X′-Y, Y-X-Y-X′ oder X-X′-Y-X angeführt.

Beispiele besonders gut geeigneter Bindemittel aus der Polymerklasse der Alkadien/Acrylnitril-Copolymerisate sind die Nitrilkautschuke, wie Butadien/Acrylnitril-Copolymerisate mit einem Acrylnitrilgehalt von 15 bis 40 Gew.%.

Beispiele besonders gut geeigneter Bindemittel aus der Polymerklasse der Ethylen/(Meth)Acrylsäure-Copolymerisate sind diejenigen, welche durch Copolymerisation von monomeren Gemischen erhältlich sind, die aus Ethylen, Acrylsäure und/oder Methacrylsäure und aus einem oder mehreren weiteren Monomeren aus der Gruppe der Vinylester, der Vinylether, Acrylsäureester, Methacrylsäureester, Acrylsäureamide und Methacrylsäureamide bestehen.

Beispiele ganz besonders bevorzugter Copolymerisate der genannten Art sind Ethylen/(Meth)Acrylsäure-Copolymerisate die n-Butylacrylat, 2-Ethylhexylacrylat und/oder ω-Methyl-poly(ethylenoxid)-α-yl-acrylat als Comonomere einpolymerisiert enthalten.

Beispiele besonders gut geeigneter Bindemittel aus der Klasse der Ethylen/Propylen-Copolymerisate sind Ethylen-Propylen-Alkadien-Terpolymerisate eines Ethylengehalts von 40 bis 80 Gew.% und eines Doppelbindungsanteils von 2 bis 20 olefinischen Doppelbindungen je 1000 Kohlenstoffatome, wobei Terpolymerisate, welche als Alkadiene Dicyclopentadien, Ethylenidennorbornen und Trans-hexa-1,4-dien einpolymerisiert enthalten, ganz besonders gut geeignet sind.

Beispiele besonders gut geeigneter Bindemittel aus der Klasse der Alkadien/(Meth)Acrylsäure-Copolymerisate sind Butadien/Methacrylsäure, Butadien/Acrylsäure- und Butadien/(Meth)Acrylsäure/(Meth)Acrylat-Copolymerisate.

Sofern in diesen polymeren Bindemitteln photopolymerisierbare olefinisch ungesättigte Reste enthalten sind, liegt deren Menge bei 1 bis 60, vorzugsweise 1,5 bis 40, Vorteilhafterweise 2 bis 30 und insbesondere 2 bis 15 Gew.%, bezogen auf die Gesamtmenge des betreffenden herzustellenden Gemischs (aₙ).

Für die Herstellung der Gemische (aₙ) werden die Photopolymerisationsinitiatoren üblicherweise in einer Menge von 0,001 bis 10, vorzugsweise 0, 1 bis 7, vorteilhafterweise 0,2 bis 5 und insbesondere 0,3 bis 4 Gew.%, bezogen auf die Gesamtmenge des betreffenden herzustellenden Gemischs (aₙ), verwendet. Hierbei kommen vor allem die üblichen und bekannten, handelsüblichen Photopolymerisationsinitiatoren in Betracht.

Für die Herstellung der Gemische (aₙ) werden die Monomere üblicherweise in einer Menge von 1 bis 60, vorzugsweise 1,5 bis 40, Vorteilhafterweise 2 bis 30 und insbesondere 2 bis 15 Gew.%, bezogen auf das betreffende herzustellende Gemisch (aₙ), verwendet. Monomere, welche für diesen Verwendungszweck gut geeignet sind, besitzen im allgemeinen einen Siedepunkt von über 100°C bei Atmosphärendruck und ein Molgewicht von bis zu 3000, insbesondere von bis zu 2000. Beispiele für geeignete Monomere sind die Ester der Acrylsäure und/oder Methacrylsäure mit ein- oder mehrwertigen Alkoholen, die Vinylester aliphatischer Monocarbonsäuren, die Diester von Fumar- und Maleinsäure oder die Umsetzungsprodukte aus OH-terminierten, oligomeren Polybutadienen mit Maleinsäure oder (Meth)Acrylsäure, d.h. oligomere Polybutadiene mit photopolymerisierbaren olefinischen Doppelbindungen. Monomere der genannten Art sind üblich und bekannt sowie im Handel erhältlich.

Für die Herstellung der Gemische (aₙ) können ferner Hilfsstoffe verwendet werden, mit deren Hilfe das anwendungstechnische Eigenschaftsprofil variiert wird. Bei diesen Hilfsstoffen handelt es sich vor allem um übliche und bekannte, im Handel erhältliche Weichmacher, Inhibitoren der thermisch initiierten Polymerisation, Farbstoffe, Pigmente, photochrome Zusätze, Mittel zur Verbesserung der Reliefstruktur, Vernetzungshilfsmittel, Antioxidantien, Antiozonantien, Füllstoffe, Flußmittel oder Formtrennmittel. Im allgemeinen werden sie in einer Menge von bis zu 40 Gew.% bezogen auf das betreffende herzustellende Gemisch (aₙ), verwendet.

Nach ihrer Herstellung liegen die Gemische (aₙ) im geschmolzenen Zustand vor und enthalten die ausgewählten Komponenten in den jeweils erforderlichen Mengen. Enthalten beispielsweise zwei Gemische (a₁) und (a₂) identische polymere Bindemittel, Photopolymerisationsinitiatoren und Monomere in identischen Mengen, so sind sie für sich gesehen photopolymerisierbar und von stofflich gleicher Zusammensetzung. Enthält indes das Gemisch (a₂) zwar die Komponenten des Gemischs (a₁), dies jedoch in unterschiedlichen Mengen, so sind beide Gemische (a₁) und (a₂) für sich gesehen photopolymerisierbar, sie weisen indes nur in etwa die gleiche stoffliche Zusammensetzung auf.

Enthält dagegen das Gemisch (a₂) Komponenten, welche zwar grundsätzlich für die Herstellung des Gemisches (a₁) in Betracht kommen, die indes darin nicht enthalten sind, so sind zwar beide Gemische (a₁) und (a₂) für sich selbst gesehen photopolymerisierbar, sie sind indes von stofflich unterschiedlicher Zusammensetzung. Hierbei kann die Abweichung in der Zusammensetzung auf die Verwendung unterschiedlicher Bindemittel, Photopolymerisationsinitiatoren, Monomere und/oder Hilfsstoffe zurückgehen. Sofern beispielsweise das Gemisch (a₂) im Gegensatz zu dem Gemisch (a₁) keine Photopolymerisationsinitiatoren enthält, so ist es für sich selbst gesehen nicht photopolymerisierbar und wird erst im Verlauf des Verfahrens durch den Kontakt mit dem aus dem photopolymerisierbaren Gemisch (a₁) hergestellten photopolymerisierbaren geschmolzenen Stoffstrom (a₁), dem photopolymerisierbaren geschmolzenen flächigen Gebilde (a₁) und/oder der photopolymerisierbaren Einzelschicht (a₁) photopolymerisierbar.

Unabhängig davon, welche Gemische (aₙ) für die Herstellung der photopolymerisierbaren Aufzeichnungsschicht (A) verwendet werden, ist es erfindungsgemäß von ganz besonderem Vorteil, wenn in den einzelnen Gemischen (aₙ) jeweils unterschiedliche Farbstoffe, Pigmente oder photochrome Zusätze enthalten sind. Demgemäß ist es für das erfindungsgemäße Verfahren von ganz besonderem Vorteil, wenn hierbei Gemische (aₙ) von stofflich in etwa gleicher oder unterschiedlicher Zusammensetzung verwendet werden.

Im weiteren Verlauf des erfindungsgemäßen Verfahrens werden die geschmolzenen Gemische (aₙ) als getrennte Stoffströme (aₙ) in geschmolzenem Zustand bereits vor ihrem Eintritt in den Kalanderspalt zusammmengeführt, ohne daß sie sich hierbei durch Verwirbelung vermischen.

Unter "Verwirbelung" wird die durch mechanische Einflüsse hervorgerufene Wirbelbildung an Phasengrenzflächen verstanden, wie sie bekanntermaßen an der Phasengrenze zweier fließender Flüssigkeiten eintritt, wobei naturgemäß ein Stoffaustausch stattfindet.

Das Zusammenführen der geschmolzenen Stoffströme (aₙ) erfolgt mittels eines sogenannten Adapters ("coextrusion feedblock"), welcher den die Stoffströme (aₙ) transportierenden Förderpumpen, Einschneckenextrudern und/oder Mehrfachwellenentgasungsextrudern gemeinsam ist. Diese Adapter sind auf dem technischen Gebiet der Coextrusion üblich und bekannt und dienen dem vermischungsfreien Zusammenführen unterschiedlicher Produktströme. Die Verwendung dieser Adapter für das vermischungsfreie Zusammenführen photopolymerisierbarer Stoffströme (aₙ) geht aus dem Stand der Technik nicht hervor.

Anstelle eines Adapters wird auch eine Mehrschichtendüse zum Zusammenführen der geschmolzenen Stoffströme (aₙ) verwendet.

In erfindungsgemäß bevorzugter Verfahrensweise werden die Gemische (aₙ) getrennt voneinander auf unterschiedlichen Mehrfachwellenentgasungsextrudern hergestellt und hierin als getrennte Stoffströme (aₙ) zu einem den Mehrfachwellenentgasungsextrudern gemeinsamen Adapter oder zu einer den Mehrfachwellenextrudern gemeinsamen Mehrschichtendüse transportiert.

Sofern man für das erfindungsgemäße Verfahren einen Adapter verwendet, ist diesem eine Breitschlitzdüse nachgeschaltet. In dieser Breitsschlitzdüse werden die unvermischten geschmolzenen Stoffströme (aₙ) noch vor ihrem Eintritt in den Kalanderspalt zu geschmolzenen flächigen Gebilden (aₙ) geformt, ohne daß sie sich hierbei durch Verwirbelung vermischen, und hiernach als übereinanderliegende geschmolzene flächige Gebilde (aₙ) ausgetragen. Hierbei hat sich in zahlreichen Fällen die Verwendung der in der EP-B-0 080 665 beschriebenen Breitschlitzdüsen bewährt, obwohl diese für den erfindungsgemäßen Verwendungszweck nicht vorgesehen waren.

Sofern man bei dem erfindungsgemäßen Verfahren für das Zusammenführen der geschmolzenen Stoffströme (aₙ) eine Mehrschichtendüse verwendet, werden die geschmolzenen Stoffströme (aₙ) in der Mehrschichtendüse bei oder unmittelbar vor ihrem Zusammenführen zu übereinanderliegenden geschmolzenen flächenförmigen Gebilden (aₙ) geformt, so daß die Verwendung eines Adapters entfällt.

Im weiteren Verlauf des erfindungsgemäßen Verfahrens werden die übereinanderliegenden geschmolzenen flächigen Gebilden (aₙ) in den Spalt eines Kalanders eingeführt. Hierbei bildet mindestens eines der beiden mit den Kalanderwalzen in Kontakt stehenden, äußeren geschmolzenen flächigen Gebilde (aₙ) einen rotierenden Massewulst. Für das Eintragen in den Kalanderspalt haben sich in zahlreichen Fällen überraschenderweise die in der EP-B-0 080 665 beschriebenen Methoden des Einführens eines einzigen geschmolzenen flächigen Gebildes (a₁) in einen Kalanderspalt bewährt, obwohl diese Methoden für den erfindungsgemäßen Verwendungszweck nicht gedacht waren.

Hierbei ist es für das erfindungsgemäße Verfahren von ganz besonderem Vorteil, wenn die Zeit zwischen dem Zusammenführen der geschmolzenen Stoffströme (aₙ) und dem Eintritt der übereinanderliegenden geschmolzenen flächigen Gebilde (aₙ) in den Kalanderspalt bei 10 Sekunden bis 5 Minuten, insbesondere 30 Sekunden bis 3 Minuten liegt.

Außerdem ist es für das erfindungsgemäße Verfahren von ganz besonderem Vorteil wenn das geschmolzene flächige Gebilde (aₙ), welches den rotierenden Massewulst ausbildet, einen um den Faktor 1,1, Vorteilhafterweise 1,2, insbesondere 1,3, höheren Schmelzflußindex ("melt flow index", mfi) hat als das unmittelbar hieran angrenzende geschmolzene flächige Gebilde (aₙ).

Hervorragende Verfahrensergebnisse werden erhalten, wenn bei dem erfindungsgemäßen Verfahren beide vorstehend genannten Bedingungen eingehalten werden.

Erfindungsgemäß werden die übereinanderliegenden geschmolzenen flächigen Gebilde (aₙ) nach ihrem Eintritt in den Kalanderspalt unter Erzeugung der aus übereinanderliegenden und haftfest miteinander verbundenen Einzelschichten (aₙ) bestehenden photopolymerisierbaren Aufzeichnungsschicht (A) kalandriert. Durch das Kalandrieren werden die Einzelschichten (aₙ) haftfest miteinander verbunden, und es wird ihre Dicke mit hoher Genauigkeit und Konstanz auf die gewünschten Werte eingestellt.

Nach dem Kalandrieren können alle oder einige der Einzelschichten (aₙ) der in erfindungsgemäßer Weise hergestellten photopolymerisierbaren Aufzeichnungsschicht (A) noch in geschmolzenem Zustand vorliegen. Sofern dies der Fall ist, kann sich dem Kalandrieren ein Kühlungsschritt anschließen.

Für das Kalandrieren in erfindungsgemäßer Weise haben sich in zahlreichen Fälle überaschenderweise die in der EP-A-0 080 665 angegebenen Kalander und Kalandrierbedingungen bewährt, obwohl sie für den erfindungsgemäßen Verwendungszweck nicht gedacht waren.

Die Gesamtdicke der in erfindungsgemäßer Verfahrensweise hergestellen photopolymerisierbaren Aufzeichnungsschicht (A) richtet sich in erster Linie nach dem Verwendungszweck der lichtempfindlichen Aufzeichnungselemente, welche eine solche photopolymerisierbare Aufzeichnungsschicht (A) enthalten oder aus dieser bestehen. So variiert die Gesamtdicke im allgemeinen von 0,001 bis 7, vorzugsweise 0,1 bis 7 und insbesondere 0,7 bis 6,5 mm, weil die lichtempfindlichen Aufzeichnungselemente mit einer solchen photopolymerisierbaren Aufzeichnungsschicht (A) nach ihrer bildmäßigen Belichtung mit aktinischem Licht und ihrer Entwicklung mit einem Entwicklerlösungsmittel photopolymerisierte Reliefschichten (A′) bilden, welche für die Mehrzahl der Drucktechniken, insbesondere aber für den Flexodruck, sowie für die Photoresisttechnik geeignet sind.

Die in erfindungsgemäßer Verfahrensweise hergestellte photopolymerisierbare Aufzeichnungsschicht (A) kann in üblicher und bekannter Weise durch nachträgliches Laminieren, Kaschieren, Kalandrieren oder Heißpressen mit einem dimensionsstabilen, gegebenenfalls eine Haftschicht aufweisenden Träger (B), einem von der Oberfläche der photopolymerisierbaren Aufzeichnungsschicht (A) leicht wieder abziehbaren temporären Schichtträger (B), einer löslichen, flexiblen Deckschicht (C) und/oder mit einer von der Oberfläche der photopolymerisierbaren Aufzeichnungsschicht (A) oder von der Oberfläche der löslichen, flexiblen Deckschicht (C) wieder leicht ablösbaren Deckfolie (D) verbunden werden.

Beispiele geeigneter dimensionsstabiler oder temporärer Schichtträger (B) sind Platten, Folien oder konische oder zylindrische Röhren (sleeves) aus Metallen, Kunststoffen oder Verbundmaterialien. Sofern als Schichtträger (B) stark reflektierende Platten oder Folien verwendet werden, können sie übliche und bekannte Lichthofschutzmittel enthalten. Die Lichthofschutzmittel können aber auch als separate Schicht auf den Schichtträgern (B) vorliegen oder in der Haftschicht enthalten sein. Beispiele geeigneter Deckschichten (C) sind beispielsweise aus der US-A-4 162 919 bekannt. Geeignete Deckfolien (D) sind üblicherweise 10 bis 250, insbesondere 20 bis 150 »m dick und bestehen im wesentlichen aus Kunststoffen, textilen Stoffen, Papieren oder Metallen. Die Oberfläche dieser Deckfolien (D), welche entweder der Deckschicht (C) oder der photopolymerisierbaren Aufzeichnungsschicht (A) unmittelbar aufliegt, kann glatt oder mattiert sein. Sofern die Oberfläche mattiert ist, prägt sich ihr Rauhheitsmuster in die darunterliegenden Schichten ein. Außerdem kann die glatte oder mattierte Oberfläche der Deckfolie (D) antihaftend ausgerüstet sein, d.h. sie kann beispielsweise eine 0,1 bis 0,5 »m dicke Antihaftschicht aus üblichen und bekannten Materialien enthalten.

Es ist indes von ganz besonderem Vorteil, die in erfindungsgemäßer Verfahrensweise herzustellende photopolymerisierbare Aufzeichnungsschicht (A) bereits während der Durchführung des erfindungsgemäßen Verfahrens mit den vorstehend angegebenen Schichtträgern (B), Deckschichten (C) und/oder Deckfolien (D) in einem Arbeitsgang zu verbinden. Hierzu werden die aus der Breitschlitzdüse oder aus der Mehrschichtendüse ausgetragenen, übereinanderliegenden geschmolzenen flächigen Gebilde (aₙ) zusammen mit den vorstehend genannten schichtförmigen Materialien in den Kalanderspalt eingeführt, worin sie in geeigneter Weise mit der photopolymerisierbaren Aufzeichnungsschicht (A) in einem Arbeitsgang verbunden werden. So kann mit Vorteil die freie Seite einer äußeren Einzelschicht (aₙ) mit einem von dieser Einzelschicht (aₙ) leicht abziehbaren temporären Schichtträger (B) oder gegebenenfalls über eine Haftschicht mit einem dimensionsstabilen Schichtträger (B) verbunden werden. Zugleich kann die freie Seite der anderen äußeren Einzelschicht (aₙ), gegebenenfalls über eine Deckschicht (C) mit einer Deckfolie (D) verbunden werden. Hierdurch resultiert in überraschend einfacher Weise ein lichtempfindliches Aufzeichnungselement, welches die in erfindungsgemäßer Weise hergestellte photopolymerisierbare Aufzeichnungsschicht (A) enthält.

Das erfindungsgemäße Verfahren weist besondere Vorteile auf. So lassen sich mit Hilfe des erfindungsgemäßen Verfahrens in einem Arbeitsgang zu ein und demselben Zeitpunkt photopolymerisierbare Aufzeichnungsschichten (A), welche aus übereinanderliegenden und haftfest miteinander verbundenen Einzelschichten (aₙ) bestehen, mit hoher Dickengenauigkeit und -konstanz herstellen. Dabei können photopolymerisierbare Aufzeichnungsschichten (A) erhalten werden, deren Einzelschichten (aₙ) die unterschiedlichsten Zusammensetzungen aufweisen, welche aber dennoch ganz besonders fest aufeinander haften. Dieser besondere Vorteil des erfindungsgemäßen Verfahrens kann nicht hoch genug eingeschätzt werden, weil nämlich eine ungenügende oder auch nur mäßige Haftung der Einzelschichten (aₙ) aufeinander die photopolymerisierbare Aufzeichnungsschicht (A) aus anwendungstechnischer Schicht praktisch wertlos macht. So aber haften die Einzelschichten (aₙ) fest aufeinander, und die hieraus bestehenden, in erfindungsgemäßer Weise hergestellten photopolymerisierbaren Aufzeichnungsschichten (A) können den unterschiedlichsten Verwendungszwecken zugeführt werden. Die besonderen Vorteile des erfindungsgemäßen Verfahrens werden daher insbesondere an den lichtempfindlichen Aufzeichnungselementen, welche die in der erfindungsgemäßen Weise hergestellte photopolymerisierbare Aufzeichnungsschicht (A) enthalten oder aus dieser bestehen, deutlich. Diese lichtempfindlichen Aufzeichnungselemente sind von hoher Dickengenauigkeit und -konstanz, was nicht nur für den Anwender, sondern auch für den Hersteller von großer Bedeutung ist. Die lichtempfindlichen Aufzeichnungselemente können daher besonders Vorteilhaft für die Herstellung von Reliefdruckplatten und Photoresists verwendet werden, wobei sie insbesondere für die Herstellung von Flexodruckplatten hervorragend geeignet sind. Hierbei erfolgt die Herstellung der Reliefdruckplatten und Photoresists aus den lichtempfindlichen Aufzeichnungselementen in üblicher und bekannter Weise durch bildmäßiges Belichten der photopolymerisierbaren Aufzeichnungsschicht (A) mit aktinischem Licht einer Wellenlänge λ von 230 bis 450, insbesondere 350 bis 450 nm und dem Entwickeln der unbelichteten Bereiche der bildmäßig belichteten photopolymerisierbaren Aufzeichnungsschicht (A) mittels geeigneter Entwicklerlösungsmittel.

Im allgemeinen variiert die Dicke der in dieser Weise erhaltenen photopolymerisierten Reliefschicht (A′) je nach Anwendungszweck von 0,001 bis 7, vorzugsweise 0, 1 bis 7 und insbesondere 0,7 bis 6,5 mm. Die so erhaltenen Reliefdruckplatten, insbesondere die Flexodruckplatten, können auf Druckzylinder aufgebracht und für den Endlosdruck verwendet werden, wogegen die betreffenden Photoresists beispielsweise der Herstellung von Leiterplatten dienen können.

Zudem kann mit Hilfe des erfindungsgemäßen Verfahrens das Eigenschaftsprofil der Reliefdruckplatten, insbesondere aber der Flexodruckplatten, über die Variation der Zusammensetzungen der Einzelschichten (aₙ) der photopolymerisierbaren Aufzeichnungsschicht (A) in gezielter und dennoch einfacher Weise eingestellt und den jeweiligen Anforderungen der Praxis Vorteilhaft angepaßt werden. Dadurch ist es möglich geworden, in einfacher Weise Reliefdruckplatten, insbesondere Flexodruckplatten, herzustellen,
- welche eine schleifbare Oberfläche aufweisen, was insbesondere bei der Herstellung nahtloser Endlosdruckformen von Vorteil ist,
- deren Oberfläche klebfrei ist und daher nicht mehr nachbehandelt werden muß,
- welche ozonresistent sind, was ihre Lebensdauer unter Druckbedingungen erheblich verlängert und ihre Wiederverwendbarkeit sichert,
- welche gegenüber Druckfarben Lösungsmitteln auf der Basis Keton/Essigester beständig sind, was ihre Anwendungsmöglichkeiten vervielfältigt,
- deren Relief einen besonders hohen optischen Kontrast aufweist, was die Qualitätskontrolle erheblich erleichtert,
- in welchen mit wäßrigen Entwicklerlösungsmitteln oder mit Wasser entwickelte photopolymerisierte Reliefschichten (A′) mit nicht wäßrig entwickelten unterschichten kombiniert sind, was sowohl das ursprünglich angewandte Entwicklungsverfahren vereinfacht und sicherer macht, als auch die Quellresistenz der photopolymerisierten Reliefschichten (A′) gegenüber einer großen Zahl von Druckfarbenlösungsmitteln erhöht,
   und/oder
- in welchem vergleichsweise harte photopolymerisierte Reliefschichten (A′) mit weichen Unterschichten kombiniert sind, was das Druckverhalten deutlich verbessert.

Bislang war es noch nicht möglich gewesen, diese Fülle vorteilhafter Eigenschaften mittels eines einzigen Verfahrens hervorzurufen, sondern es waren hierbei stets mehrere unterschiedliche Verfahren anzuwenden, um wenigstens einen Teil dieser Vorteile zugleich zu realisieren.

Das erfindungsgemäße Verfahren wird anhand des folgenden Beispiels näher erläutert.

### Beispiel 1

Die Herstellung eines lichtempfindlichen Aufzeichnungselements nach dem erfindungsgemäßen Verfahren und die Verwendung dieses lichtempfindlichen Aufzeichnungselements für die Herstellung einer Flexodruckplatte.

Das der Herstellung der photopolymerisierbaren Aufzeichnungsschicht (A) dienende photopolymerisierbare Gemisch (a₁) bestand aus 81,8 Gew.% eines Dreiblockkautschuks des Aufbaus Styrol/Isopren/Styrol (Cariflex ® 1107 der Shell AG) (polymeres Bindemittel), 1,2 Gew.% Benzildimethylacetal (Photopolymerisationsinitiator), 2,0 Gew.% 2,6-Di-tert.-butyl-p-kresol (Inhibitor der thermisch initiierten radikalischen Polymerisation), 5, 0 Gew.% 1,6-Hexandioldiacrylat (Monomer) und 10,0 Gew.% Paraffinöl (Weißöl S 5000, Weichmacher). Das photopolymerisierbare Gemisch (a₁) wurde in üblicher und bekannter Weise auf einem Zweiwellenentgasungsextruder hergestellt und hierin als geschmolzener Stoffstrom (a₁) zu einer Zweischichtendüse transportiert. Hierbei lag die maximale Temperatur des geschmolzenen Stoffstroms (a₁) bei 155°C, der Stoffdurchsatz war 30 kg/Stunde, und die Verweilzeit im Extruder lag bei 5 Minuten. Vor seinem Eintritt von unten in die Zweischichtendüse passierte der geschmolzene Stoffstrom (a₁) ein 40 »m Metallgewebefilter.

Das der Herstellung der photopolymerisierbaren Aufzeichnungsschicht (A) dienende photopolymerisierbare Gemisch (a₂) bestand aus 71,497 Gew.% eines Terpolymeren aus 58 Gew.-Teilen Ethylen, 21 Gew.-Teilen Acrylsäure und 21 Gew.-Teilen 2-Ethylhexylacrylat (Bindemittel), 6 Gew.% Glycidylmethacrylat (Monomer), 15 Gew.% N-n-Butylbenzolsulfonsäureamid (Cetamoll ® BMB der BASF AG, Weichmacher), 5 Gew.% Butylethanolamin (Weichmacher), 1,2 Gew.% Benzildimethylacetal (Photopolymerisationsinitiator), 0,8 Gew.% N-Nitroso-N-cyclohexylhydroxylamin-kaliumsalz kombiniert mit 0,003 Gew.% Safranin T (C.I. 50240) (photochromer Zusatz, sensitometrischer Regler) und 0,5 Gew.% 2,6-Di-tert.-butyl-p-kresol (Inhibitor der thermisch initiierten radikalischen Polymerisation). Es wurde separat vom photopolymerisierbaren Gemisch (a₁) auf einem Zweiwellenentgasungsextruder hergestellt und als geschmolzener Stoffstrom (a₂) zur Zweischichtendüse transportiert. Hierbei lag die maximale Temperatur des geschmolzenen Stoffstroms (a₂) bei 140°C, der Stoffdurchsatz war 10 kg/Stunde, und die Verweilzeit im Extruder lag bei 7 Minuten. Vor seinem Eintritt in die Zweischichtendüse von oben passierte der geschmolzene Stoffstrom (aₙ) ein 40 »m Metallgewebefilter.

Die Schmelzflußindices der Stoffströme (a₁) und (a₂) wurden separat in üblicher und bekannter Weise unter einem Gewicht von 0,6 kg nach DIN 53735 bestimmt. Hierbei erwies sich der Stoffstrom (a₁) mit einem Schmelzflußindex bei 150°C von 2 g/10 Minuten als höherviskos als der Stoffstrom (a₂) mit einem Schmelzflußindex bei 150°C von 100 g/10 Minuten. Der Stoffstrom (a₂) wies demnach einen um den Faktor 50 höheren Schmelzflußindex auf als der Stoffstrom (a₁).

Die beiden geschmolzenen Stoffströme (a₁) und (a₂) wurden in der Zweischichtendüse zusammengeführt, wobei der geschmolzene Stoffstrom (a₁) von unten und der geschmolzene Stoffstrom (a₂) von oben her eingespeist wurde. Die beiden Stoffströme (a₁) und (a₂) wurden als übereinanderliegende geschmolzene flächige Gebilde (a₁) und (a₂) der Breite 33,5 cm bei einer Düsentemperatur von 145°C ausgetragen und hiernach unmittelbar in den Spalt eines Kalanders eingeführt, wobei das niedriger viskose geschmolzene flächige Gebilde (a₂) den Massewulst ausbildete. Die Verweilzeit zwischen dem Zusammenführen der übereinanderliegenden geschmolzenen flächigen Gebilde (a₁) und (a₂) und dem Entritt in den Kalanderspalt lag bei 30 Sekunden. Die Temperatur der Kalanderwalzen lag bei 80°C.

Zusammen mit den übereinanderliegenden geschmolzenen flächigen Gebilden (a₁) und (a₂) wurden auf der Seite des flächigen Gebildes (a₁) eine mit einem Haftlack beschichtete Trägerfolie (dimensionsstabiler Schichtträger B) und auf der Seite des flächigen Gebildes (a₂) eine mit einer Deckschicht (C) beschichtete Deckfolie (D) in den Kalanderspalt eingeführt. Hierbei wurden als Deck- und Trägerfolien 125 »m starke biaxial gereckte Polyethylenterephthalatfolien verwendet. In ihrer Funktion als Deckfolie (D) waren sie einseitig mit einer 5 »m starken Schicht aus einem Polyvinylalkohol/Ethylenoxid-Blockcopolymeren (Mowiol ® 04/M1 der Hoechst AG) (Deckschicht C) beschichtet. In ihrer Funktion als Trägerfolie (B) waren sie einseitig mit einer 5 »m starken Polyurethanhaftlackschicht versehen.

Beim Kalandrieren im Kalanderspalt wurden die übereinanderliegenden geschmolzenen flächigen Gebilde (a₁) und (a₂) zu einer 2100 »m dicken Einzelschicht (a₁) und zu einer 700 »m dicken Einzelschicht (a₂) geformt, wobei die beiden Einzelschichten (a₁) und (a₂) zugleich haftfest miteinander zu der photopolymerisierbaren Aufzeichnungsschicht (A) verbunden wurden. Insgesamt resultierte ein lichtempfindliches Aufzeichnungselement, in welchem die 125 »m dicke Trägerfolie, die 5 »m dicke Haftlackschicht, die 2100 »m dicke Einzelschicht (a₁), die 700 »m dicke Einzelschicht (a₂), die Deckschicht (C) und die Deckfolie (D) in der angegebenen Reihefolge übereinanderlagen, wobei die beiden Einzelschichten (a₁) und (a₂) zusammen die photopolymerisierbare Aufzeichnungsschicht (A) bildeten.

Diesem in erfindungsgemäßer Weise hergestellten lichtempfindlichen Aufzeichnungselement wurden Proben entnommen, anhand derer festgestellt werden konnte, daß auch die nicht photopolymerisierten Einzelschichten (a₁) und (a₂) bereits haftfest miteinander verbunden und durch eine saubere Phasengrenze voneinander abgegrenzt waren. Dies bedeutete, daß die beiden Einzelschichten (a₁) und (a₂) über die gesamte Breite und Länge der photopolymerisierbaren Aufzeichnungsschicht (A) hinweg von konstanter Dicke waren, was die Vorteilhaftigkeit des erfindungsgemäßen Verfahrens weiter untermauert.

Das nach dem erfindungsgemäßen Verfahren hergestellte lichtempfindliche Aufzeichnungselement wurde zu einer Flexodruckplatte weiterverarbeitet.

Hierzu wurde zunächst die Deckfolie (D) von dem lichtempfindlichen Aufzeichnungselement abgezogen. Anschließend wurde auf die Deckschicht (C) eine Negativvorlage aufgelegt, wonach man die photopolymerisierbare Aufzeichnungsschicht (A) durch die Negativvorlage hindurch während 15 Minuten im Vakuum in einem 100 Watt Röhrenbelichter bildmäßig belichtete. Anschließend wurde die bildmäßig belichtete Aufzeichnungsschicht (A) mit einem Entwicklerlösungsmittel (1 % Natriumcarbonat in Wasser) bei 60°C während 10 Minuten in einem Bürstenwascher entwickelt. Bedingt durch die stoffliche Zusammensetzung, wurden hierbei nur die unbelichteten Anteile der bildmäßig belichteten Einzelschicht (a₂) der Aufzeichnungsschicht (A) weggewaschen, wogegen die in wäßrigen Entwicklerlösungsmitteln nicht lösliche oder quellbare bildmäßig belichtete Einzelschicht (a₁) nicht angegriffen wurde. Anschließend wurde das bildmäßig belichtete und entwickelte Aufzeichnungselement während 2 Stunden bei 65°C getrocknet, wonach man es während 10 Minuten von der Seite der photopolymerisierten Reliefschicht (A′) (vormals die Einzelschicht (a₂) der photopolymerisierbaren Aufzeichnungsschicht (A)) und während 10 Minuten von der Seite des dimensionsstabilen Trägers (B) her vollflächig mit aktinischem Licht nachbelichtete. Hiernach wurde das Aufzeichnungselement während 10 Minuten mit kurzwelligem UV-Licht einer Wellenlänge λ von < 300 nm bestrahlt, wonach die Herstellung der Flexodruckplatte abgeschlossen war.

Überraschenderweise konnte die Herstellung der Flexodruckplatte innerhalb eines Tages abgeschlossen werden, was eine erhebliche Verkürzung der Verfahrenszeiten im Vergleich zu bekannten Verfahren bedeutet.

Die einzelnen Elemente der photopolymerisierten Reliefschicht (A′) (vormals die Einzelschicht (a₂) der photopolymerisierbaren Aufzeichnungsschicht (A)) waren auf der vollständig polymerisierten Einzelschicht (a₁) einwandfrei versockelt und wiesen eine hervorragende Haftung auf. Das Relief war insgesamt hervorragend ausgebildet und wies nur gerade Reliefflanken und steile Reliefkanten auf. Unterschneidungen von Reliefteilen durch Überwaschung konnten nicht beobachtet werden. Der Reliefgrund war gleichmäßig glatt und klebfrei. Die Reliefhöhe selbst war innerhalb von ± 10 »m konstant.

Die Flexodruckplatte wurde auf einen Druckzylinder aufgespannt und in einem Flexodruckwerk für den Endlosdruck verwendet. Hierbei kamen die üblichen und bekannten Flexodruckfarben zum Einsatz. Die Flexodruckplatte lieferte in hoher Auflage ausgezeichnete Drucke, welche keinerlei Informationsverlust gegenüber der Negativvorlage aufwiesen.

## Patentansprüche

1. Kontinuierliches Verfahren zur Herstellung eines lichtempfindlichen Aufzeichnungselements mit einer photopolymerisierbaren Aufzeichnungsschicht (A), bei welchem die photopolymerisierbare Aufzeichnungsschicht (A) aus mindestens zwei übereinanderliegenden und haftfest miteinander verbundenen Einzelschichten (aₙ) von stofflich gleicher, in etwa gleicher oder unterschiedlicher Zusammensetzung durch deren haftfestes Verbinden im Spalt eines Kalanders in einem Arbeitsgang erzeugt wird, dadurch gekennzeichnet, daß man hierbei
(1) die der Herstellung der Einzelschichten (aₙ) dienenden Gemische (aₙ) getrennt voneinander aufschmilzt und als getrennte Stoffströme (aₙ) in geschmolzenem Zustand bereits vor ihrem Eintritt in den Kalanderspalt zusammenführt, ohne sie dabei durch Verwirbelung zu vermischen, wobei
(2) die geschmolzenen Stoffströme (aₙ) vor ihrem Eintritt in den Kalanderspalt bereits vor, bei oder unmittelbar nach ihrem Zusammenführen zu übereinanderliegenden geschmolzenen flächigen Gebilden (aₙ) geformt werden, ohne sie dabei durch Verwirbelung zu vermischen, wonach man
(3) die übereinanderliegenden geschmolzenen flächigen Gebilde (aₙ) in den Kalanderspalt einführt, wobei mindestens eines der beiden mit den Kalanderwalzen in Kontakt stehenden, äußeren geschmolzenen flächigen Gebilde (aₙ) einen rotierenden Massewulst bildet, und
(4) die übereinanderliegenden geschmolzenen flächigen Gebilde (aₙ) unter Erzeugung der aus übereinanderliegenden und haftfest miteinander verbundenen Einzelschichten (aₙ) bestehenden photopolymerisierbaren Aufzeichnungsschicht (A) kalandriert.

2. Das Verfahren nach Anspruch 1, dadurch gekennzeichnet, daß die Zeit zwischen dem Zusammenführen der geschmolzenen Stoffströme (aₙ) und dem Eintritt der übereinanderliegenden geschmolzenen flächigen Gebilde (aₙ) in den Kalanderspalt bei 10 Sekunden bis 5 Minuten liegt.

3. Das Verfahren nach einem der Ansprüche 1 oder 2, dadurch gekennzeichnet, daß beim Eintritt in den Kalanderspalt das geschmolzene flächige Gebilde (aₙ), welches den rotierenden Massewulst ausbildet, einen um den Faktor 1,1 größeren Schmelzflußindex (melt flow index, mfi) hat als das hieran unmittelbar angrenzende geschmolzene flächige Gebilde (aₙ).

4. Das Verfahren nach einem der Ansprüche 1 bis 3, dadurch gekennzeichnet, daß man die geschmolzenen Stoffströme (aₙ) in einem Adapter zusammenführt und aus einer dem Adapter nachgeschalteten Breitschlitzdüse als übereinanderliegende geschmolzene flächige Gebilde (aₙ) austrägt.

5. Das Verfahren nach einem der Ansprüche 1 bis 3, dadurch gekennzeichnet, daß man die geschmolzenen Stoffströme (aₙ) in einer Mehrschichtendüse zusammenführt und als übereinanderliegende geschmolzene flächige Gebilde (aₙ) austrägt.

6. Das Verfahren nach einem der Ansprüche 4 oder 5, dadurch gekennzeichnet, daß die geschmolzenen Gemische (aₙ) getrennt voneinander auf Mehrfachwellenentgasungsextrudern hergestellt und hierin als geschmolzene Stoffströme (aₙ) zum Adapter oder zu der Mehrschichtendüse transportiert werden.

7. Das Verfahren nach einem der Ansprüche 4 oder 5, dadurch gekennzeichnet, daß die geschmolzenen Gemische (aₙ) auf Einschneckenextrudern hergestellt und hierin als geschmolzene Stoffströme (aₙ) zum Adapter oder zu der Mehrschichtendüse transportiert werden.

8. Das Verfahren nach einem der Ansprüche 4 oder 5, dadurch gekennzeichnet, daß die geschmolzenen Gemische (aₙ) getrennt voneinander auf Mischgeräten hergestellt und als geschmolzene Stoffströme (aₙ) mittels Einschneckenextrudern, Mehrfachwellenentgasungsextrudern oder Förderpumpen zum Adapter oder zu der Mehrschichtendüse transportiert werden.

9. Das Verfahren nach einem der Ansprüche 4 bis 8, dadurch gekennzeichnet, daß die geschmolzenen Stoffströme (aₙ) vor ihrer Zusammenführung im Adapter oder in der Mehrschichtendüse filtriert werden.

10. Das Verfahren nach einem der Ansprüche 1 bis 9, dadurch gekennzeichnet, daß mindestens ein geschmolzener Stoffstrom (aₙ) für sich gesehen photopolymerisierbar ist und im Verlauf des Verfahrens eine photopolymerisierbare Einzelschicht (aₙ) bildet, wogegen jeder weitere geschmolzene Stoffstrom (aₙ) erst bei oder nach dem Kontakt mit mindestens diesem einen photopolymerisierbaren geschmolzenen Stoffstrom (aₙ) photopolymerisierbar wird und hiernach gleichfalls eine photopolymerisierbare Einzelschicht (aₙ) bildet.

11. Das Verfahren nach einem der Ansprüche 1 bis 10, dadurch gekennzeichnet, daß die übereinanderliegenden Einzelschichten (aₙ) im Kalanderspalt auf einer freien Seite mit einem temporärem Schichtträger (B), welcher sich wieder leicht von der Oberfläche der betreffenden äußeren Einzelschicht (aₙ) abziehen läßt, verbunden werden.

12. Das Verfahren nach einem der Ansprüche 1 bis 10, dadurch gekennzeichnet, daß die übereinanderliegenden Einzelschichten (aₙ) im Kalanderspalt auf einer freien Seite haftfest mit einem dimensionsstabilen Träger (B) verbunden werden.

13. Das Verfahren nach Anspruch 12, dadurch gekennzeichnet, daß die übereinanderliegenden Einzelschichten (aₙ) im Kalanderspalt auf einer freien Seite über eine Haftschicht mit dem dimensionsstabilen Träger (B) verbunden werden.

14. Das Verfahren nach einem der Ansprüche 1 bis 13, dadurch gekennzeichnet, daß die übereinanderliegenden Einzelschichten (aₙ) im Kalanderspalt auf einer freien Seite mit einer glatten oder mattierten Deckfolie (D), welche sich leicht wieder von der Oberfläche der betreffenden Einzelschicht (aₙ) ablösen läßt, verbunden werden.

15. Das Verfahren nach einem der Ansprüche 1 bis 13, dadurch gekennzeichnet, daß die übereinanderliegenden Einzelschichten (aₙ) im Kalanderspalt auf einer freien Seite über eine glatte oder mattierte Deckschicht (C) mit einer Deckfolie (D), welche sich leicht wieder von der Oberfläche der betreffenden Deckschicht (C) ablösen läßt, verbunden werden.

16. Verwendung der gemäß einem der Ansprüche 1 bis 15 hergestellten lichtempfindlichen Aufzeichnungselemente als lichtempfindliche Reliefdruckplatten.

17. Verwendung der nach einem der Ansprüche 1 bis 15 hergestellten lichtempfindlichen Aufzeichnungselemente als lichtempfindliche Flexodruckplatten.

## Claims

1. A continuous process for the production of a photosensitive recording element having a photopolymerizable recording layer (A), in which the photopolymerizable recording layer (A) is produced from two or more individual strata (aₙ) which lie one on top of the other, are firmly bonded to one another and have the same or roughly the same composition or different compositions, by firmly bonding the said strata in the nip of a calender in one operation, which comprises
(1) melting the mixtures (aₙ) used for the production of the individual strata (aₙ) separately from one another and combining them as separate material streams (aₙ) in the molten state even before they enter the calender nip, without mixing them through turbulence,
(2) shaping the molten material streams (aₙ) before they enter the calender nip, before, during or directly after combination of said streams, to give molten sheet-like structures (aₙ) lying one on top of the other, without mixing them through turbulence, and then
(3) introducing the molten sheet-like structures (aₙ) lying one on top of the other into the calender nip, one or both of the two outer molten sheet-like structures (aₙ) in contact with the calender rollers forming a rotating melt bead, and
(4) calendering the molten sheet-like structures (aₙ) lying one on top of the other with production of the photopolymerizable recording layer (A) consisting of individual strata (aₙ) which lie one on top of the other and are firmly bonded to one another.

2. A process as claimed in claim 1, wherein the time between the combination of the molten material streams (aₙ) and entry of the molten sheet-like structures (aₙ) lying one on top of the other into the calender nip is from 10 seconds to 5 minutes.

3. A process as claimed in claim 1 or 2, wherein, on entering the calender nip, the molten sheet-like structure (aₙ) which forms the rotating melt bead has a melt flow index (MFI) which is 1.1 times greater than that of the directly adjacent molten sheet-like structure (aₙ).

4. A process as claimed in any of claims 1 to 3, wherein the molten material streams (aₙ) are combined in an adapter and are extruded from a slot die downstream of the adapter, as molten sheet-like structures (aₙ) lying one on top of the other.

5. A process as claimed in any of claims 1 to 3, wherein the molten material streams (aₙ) are combined in a multilayer die and extruded as molten sheet-like structures (aₙ) lying one on top of the other.

6. A process as claimed in claim 4 or 5, wherein the molten mixtures (aₙ) are prepared separately from one another in multiscrew devolatilization extruders and are transported therein as molten material streams (aₙ) to the adapter or to the multilayer die.

7. A process as claimed in claim 4 or 5, wherein the molten mixtures (aₙ) are prepared in single-screw extruders and are transported therein as molten material streams (aₙ) to the adapter or to the multilayer die.

8. A process as claimed in claim 4 or 5, wherein the molten mixtures (aₙ) are prepared separately from one another in mixers and are transported as molten material streams (aₙ), by means of single-screw extruders, multi-screw devolatilization extruders or delivery pumps, to the adapter or to the multilayer die.

9. A process as claimed in any of claims 4 to 8, wherein the molten material streams (aₙ) are filtered before being combined in the adapter or the multilayer die.

10. A process as claimed in any of claims 1 to 9, wherein one or more molten material streams (aₙ) are themselves polymerizable and form a photopolymerizable individual stratum (aₙ) in the course of the process, whereas each further molten material stream (aₙ) becomes photopolymerizable only during or after contact with one or more of these photopolymerizable molten material streams (aₙ) and thereafter likewise forms a photopolymerizable individual stratum (aₙ).

11. A process as claimed in any of claims 1 to 10, wherein the individual strata (aₙ) lying one on top of the other are bonded in the calender nip, on a free side, to a temporary base (B), which can readily be peeled off again from the surface of the relevant outer individual stratum (aₙ).

12. A process as claimed in any of claims 1 to 10, wherein the individual strata (aₙ) lying one on top of the other are firmly bonded in the calender nip, on a free side, to a dimensionally stable base (B).

13. A process as claimed in claim 12, wherein the individual strata (aₙ) lying one on top of the other are bonded in the calender nip, on a free side, via an adhesion-promoting layer, to the dimensionally stable base (B).

14. A process as claimed in any of claims 1 to 13, wherein the individual strata (aₙ) lying one on top of the other are bonded in the calender nip, on a free side, to a smooth or matt cover sheet (D), which can readily be detached again from the surface of the relevant individual stratum (aₙ).

15. A process as claimed in any of claims 1 to 13, wherein the individual strata (aₙ) lying one on top of the other are bonded in the calender nip, on a free side, via a smooth or matt top layer (C), to a cover sheet (D), which can readily be detached again from the surface of the relevant top layer (C).

16. The use of the photosensitive recording elements prepared as claimed in any of claims 1 to 15 as photosensitive relief printing plates.

17. The use of photosensitive recording elements prepared as claimed in any of claims 1 to 15 as photosensitive flexographic printing plates.

## Revendications

1. Procédé continu de préparation d'un élément d'enregistrement sensible à la lumière, comportant une couche d'enregistrement photopolymérisable (A), dans lequel la couche d'enregistrement photopolymérisable (A) est produite, en une seule opération, à partir d'au moins deux couches individuelles superposées (aₙ) de composition matérielle identique, à peu près identique ou différente, par liaison adhésive desdites couches dans l'espace comprise entre deux cylindres d'une calandre, ce procédé étant caractérisé par le fait que
(1) les mélanges (aₙ) servant à la préparation des couches individuelles (aₙ) sont mis à fondre séparément et sont réunis, à l'état fondu, comme courants de matière (aₙ) distincts, dès avant leur entrée dans l'espace compris entre deux cylindres, sans subir de mélange par tourbillonnement,
(2) les courants de matière fondue (aₙ), avant leur entrée dans l'espace compris entre deux cylindres, avant, pendant ou directement après leur réunion, sont mis sous forme d'éléments plans superposés, fondus (aₙ), sans subir de mélange par tourbillonnement, ensuite
(3) les éléments plans fondus, superposés (aₙ) sont introduits dans l'espace comprise entre deux cylindres, au moins un des deux éléments plans extérieurs, fondus (aₙ), en contact avec les cylindres de la calandre, formant alors un bourrelet de matière en rotation, et
(4) les éléments plans fondus, superposés (aₙ), sont calandrés avec formation de la couche d'enregistrement photopolymérisable (A), constituée des couches individuelles superposés (aₙ), reliées entre elles de manière adhérente.

2. Procédé selon la revendication 1, caractérisé par le fait que le temps compris entre la réunion des courants de matière fondus (aₙ) et l'entrée des éléments plans fondus, superposés (aₙ), dans l'espace compris entre deux cylindres varie entre 10 secondes et 5 minutes.

3. Procédé selon l'une des revendications 1 ou 2, caractérisé par le fait qu'à l'entrée dans l'espace compris entre deux cylindres, l'élément plan fondu (aₙ), qui forme le bourrelet de matière rotatif, présente un indice de fusion (melt flow index, mfi) d'un facteur 1,1 supérieur à celui de l'élément plan, fondu (aₙ) directement adjacent.

4. Procédé selon l'une des revendications 1 à 3, caractérisé par le fait que les courants de matière fondus (aₙ) sont réunis dans un adaptateur et sont évacués sous forme d'éléments plans fondus, superposés (aₙ) à tavers une filière plate prévue à la suite de l'adaptateur.

5. Procédé selon l'une des revendications 1 à 3, caractérisé par le fait que les courants de matière fondus (aₙ) sont réunis dans une filière multiple et sont évacués sous forme d'éléments plans fondus, superposés (aₙ).

6. Procédé selon l'une des revendications 4 ou 5, caractérisé par le fait que les mélanges fondus (aₙ) sont préparés séparément, dans des boudineuses de dégazage à plusieurs arbres, d'où ils sont transportés, sous forme de courants de matière fondus (aₙ), vers l'adaptateur ou la filière multiple.

7. Procédé selon l'une des revendications 4 ou 5, caractérisé par le fait que les mélanges fondus (aₙ) sont préparés dans des boudineuses à une vis d'où ils sont transportés, sous forme de courants de matière fondue (aₙ), vers l'adaptateur ou la filière multiple.

8. Procédé selon l'une des revendications 4 ou 5, caractérisé par le fait que les mélanges fondus (aₙ) sont préparés, séparément les uns des autres dans des mélangeurs et sont transportés, sous forme de courants de matière fondue (aₙ) vers l'adaptateur ou la filière multiple au moyen de boudineuses à vis, boudineuses de dégazage à plusieurs arbres ou pompes transporteuses.

9. Procédé selon l'une des revendications 4 à 8, caractérisé par le fait que les courants de matière fondue (aₙ), avant leur réunion dans l'adaptateur ou dans la filière multiple, sont filtrés.

10. Procédé selon l'une des revendications 1 à 9, caractérisé par le fait qu'au moins un courant de matière fondue (aₙ) est, comme tel, photopolymérisable et forme, pendant le procédé, une couche individuelle photopolymérisable (aₙ), alors que chaque autre courant de matière fondue (aₙ) ne devient photopolymérisable qu'au contact, ou après le contact avec, au moins, ce seul courant de matière fondu photopolymérisable (aₙ) en formant alors à son tour une couche individuelle photopolymérisable (aₙ).

11. Procédé selon l'une des revendications 1 à 10, caractérisé par le fait que les couches individuelles superposées (aₙ) sont pourvues dans l'espace compris entre deux cylindres, sur une face libre, d'un support de couche (b) temporaire, qui peut être enlevé facilement de la surface de la couche individuelle extérieure respective (aₙ).

12. Procédé selon l'une des revendications 1 à 10, caractérisé par le fait que les couches individuelles superposées (aₙ) sont reliées de façon adhérente, dans l'espace compris entre deux cylindres, sur une face libre avec un support (B) à stabilité dimensionnelle.

13. Procédé selon la revendication 12, caractérisé par le fait que les couches individuelles superposées (aₙ) sont pourvues, dans l'espace compris entre deux cylindres, sur une face libre, par l'intermédiaire d'une couche adhérente, du support (B) à stabilité dimensionnelle.

14. Procédé selon l'une des revendications 1 à 13, caractérisé par le fait que les couches individuelles superposées (aₙ), dans l'espace compris entre deux cylindres, sont recouvertes, sur une face libre, d'une feuille de recouvrement (D) lisse ou dépolie, qui peut être facilement enlevée de la surface de la couche individuelle respective (aₙ).

15. Procédé selon l'une des revendications 1 à 13, caractérisé par le fait que les couches individuelles superposées (aₙ) sont recouvertes, dans l'espace compris entre deux cylindres de la calandre, sur une face libre, par l'intermédiaire d'une couche de recouvrement (C) lisse ou dépolie, d'une feuille de recouvrement (D) qui peut être facilement retirée de la surface de la couche de recouvrement (C) respective.

16. Utilisation des éléments d'enregistrement sensibles à la lumière, préparés selon l'une des revendications 1 à 15, comme clichés d'impression en relief sensibles à la lumière.

17. Utilisation des éléments d'enregistrement sensibles à la lumière, préparés selon l'une des revendications 1 à 15, comme clichés flexographiques sensibles à la lumière.
